# EUROPEAN PATENT SPECIFICATION

(11) **EP 1 814 120 B1**
(45) Date of publication and mention of the grant of the patent: **04.03.2009**
(21) Application number: 07100691.0
(22) Date of filing: 17.01.2007
(51) Int. Cl.: G11C 11/15, G11C 11/16

(54) **Magnetic memory unit using magnetic domain dragging and method of operating the same**
Magnetischer Domain-Verschiebungsspeicher und Betriebsverfahren
Mémoire magnétique à décalage de domaines et procédé d'operation

(30) Priority: 26.01.2006 KR 20060008242
(43) Date of publication of application: 01.08.2007
(73) Proprietor: Samsung Electronics Co., Ltd., Yeongtong-gu Suwon-si, Gyeonggi-do (KR)
(72) Inventor: Kim, Kee-won, Samsung Advanced Institute of Technology, Gyeonggi-do (KR); Kim, Tae-wan, Samsung Advanced Institute of Technology, Gyeonggi-do (KR); Cho, Young-jin, Samsung Advanced Institute of Technology, Gyeonggi-do (KR); Hwang, In-jun, Samsung Advanced Institute of Technology, Gyeonggi-do (KR)
(74) Representative: Greene, Simon Kenneth

(56) References cited:
- EP-A2- 1 320 102
- US-A1- 2004 251 232
- US-A1- 2005 078 511

## Description

### BACKGROUND OF THE INVENTION

The present invention relates to a magnetic device unit, and more particularly, to a magnetic device unit writing and reading a plurality of bits of data using magnetic domain dragging technique, and a method of operating the same.

Magnetic devices for information storage can be roughly classified into memory devices and storage devices. Memory devices require improvements in solid-state performance and storage devices require improvements in storage capacity.

A magnetic random access memory (MRAM) is a kind of non-volatile memory device and a new solid-state magnetic memory that uses a magnetic resistance effect based on spin-dependent conduction phenomena of a nano magnetic material. That is, an MRAM uses giant magnetoresistance (GMR) or tunnel magnetoresistance (TMR) generated by a significant influence on an electron transport phenomenon from spin. Here spin is a degree of freedom of electrons.

GMR is a resistance difference generated when ferromagnetic materials having a non-magnetic material interposed therebetween have the same magnetization directions and have reverse magnetization directions in an adjoining arrangement of ferromagnetic material/ metallic non-magnetic material/ ferromagnetic material. TMR is resistance where a current easily flows when two ferromagnetic materials have the same magnetization directions in an adjoining arrangement of ferromagnetic material/ insulator/ ferromagnetic material compared to when the two ferromagnetic materials have reverse magnetization directions. Since an MRAM using GMR has a relatively small resistance difference caused by a magnetization direction, a large voltage difference cannot be achieved. Also, since MRAMs have a disadvantage that the size of a metal oxide semiconductor field effect transistor (MOSFET) combining with a GMR layer to constitute a cell is large, research for pursuing commercialization of MRAMs with a TMR layer is currently being more actively conducted.

The MRAM may consist of a transistor, which is a switching device, and a magnetic tunnel junction (MTJ) cell in which data is stored. Generally, the MTJ cell may consist of a pinned ferromagnetic layer having a pinned magnetization direction, a free ferromagnetic layer whose magnetization direction may be parallel to or anti-parallel to the pinned magnetization direction of the pinned ferromagnetic layer, and a non-magnetic layer located between the pinned ferromagnetic layer and the free ferromagnetic layer, and magnetically separating the pinned ferromagnetic layer and the free ferromagnetic layer.

However, since a general MRAM stores only one bit of data per MTJ cell, there is a limitation in increasing the data storage capacity of the MRAM. Therefore, a new storage technology is required in order to increase the information storage capacity of a magnetic memory such as the MRAM.

US 2004/0251232 where on the preamble of claim 1 is based describes a shiftable magnetic shift register in which magnetic domains are shifted by supplying a current. The site of the magnetic domains is determined by matches there between.

EP 1320102 describes an MRAM structure with a free layer, fixed layer and a non-magnetic layer. The site of the magnetic domains is determined by the MRAM cell dimensions.

### SUMMARY OF THE INVENTION

The present invention provides a magnetic device unit using magnetic domain dragging technique to store a plurality of bits of data or read the stored data when a magnetic domain wall is formed on a free layer to form a plurality of magnetic domains, and a method of operating the same.

According to an aspect of the present invention, there is provided a magnetic device unit according to claim 1.

The writing signal may be a switching current in a pulse form.

The reading signal may be a pulse current smaller than the switching current,

One of the switching current and the pulse current for reading, and the dragging signal may be inputted alternately, so that one of a data storing operation and a data reading operation, and magnetic domain dragging operation may be performed alternately.

The data bit region may include at least one magnetic domain, and magnetic domain dragging is performed by a data bit region unit.

The data bit region may include at least one magnetic domain, and magnetic domain dragging is performed by a data bit region unit,

The magnetic device unit may further include a non-magnetic layer between the reference layer and the free layer.

The non-magnetic layer may be a conduction layer or an insulation layer serving as a tunneling barrier.

The magnetic device unit may further include a buffer cell that adjoins the data storage cell and is formed on at least one side of the data storage cell to store data dragged beyond an outside of the data storage cell region according to magnetic domain dragging.

A plurality of data storage cells may be formed. The buffer cell may be located between two adjacent data storage cells. At least one first input portion may be formed per data storage cell.

The plurality ,of data storage cells may be formed in an array, and the at least one first input portion may be disposed corresponding to each of the data storage cells.

According to another aspect of the present invention, there is provided a method of operating a magnetic device unit according to claim 13.

### BRIEF DESCRIPTION OF THE DRAWINGS

The above and other features and advantages of the present invention will become more apparent by describing in detail exemplary embodiments thereof with reference to the attached drawings in which:
FIGS. 1 and 2 are views of a magnetic device unit according to an embodiment of the present invention;
FIGS. 3A through 3C are views illustrating that a magnetization direction of a third data bit region (a specific data bit region) of FIGS. 1 and 2 is reversed by applying a switching current and then reversed magnetization direction of the third data bit region is dragged to an adjacent fourth data bit region by a dragging current;
FIGS. 4A and 4B are views illustrating that a magnetization direction of a third data bit region (a specific data bit region) is read by applying a reading pulse current to the third data bit region and is dragged to an adjacent fourth data bit region by a dragging current;
FIG. 5 is a graph of a dragging current signal Pulse 1 (Dragging), reading pulse current signal Pulse 2 (reading), and a switching writing pulse current signal Pulse 2 (writing), which are applied to a magnetic device unit according to an embodiment of the present invention; and
FIG. 6 is view of a magnetic device unit according to another embodiment of the present invention.

### DETAILED DESCRIPTION OF THE INVENTION

The present invention will now be described more fully with reference to the accompanying drawings, in which exemplary embodiments of the invention are shown.

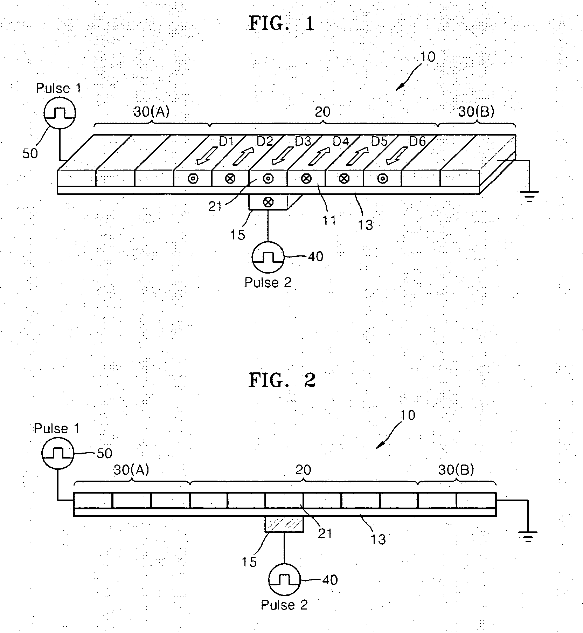

FIGS. 1 and 2 are views of a magnetic device unit 10 according to an embodiment of the present invention.

Referring to FIGS. 1 and 2, the magnetic device unit 10 includes a data storage cell 20, a first input portion 40, and a second input portion 50. The data storage cell 20 stores a plurality of bits of data. The first input portion 40 inputs one signal Pulse 2 of a writing signal and a reading signal. The second input portion 50 inputs a dragging signal Pulse 1 for dragging a magnetic domain.

The data storage cell 20 of the magnetic device unit 10 includes a free layer 11 and a reference layer 15. The free layer 11 can be switched magnetization direction and has a plurality of adjoining magnetic domains. The reference layer 15 is formed to correspond to a portion of the free layer 11. A non-magnetic layer 13 may be arranged between the reference layer 15 and the free layer 11. According to the current embodiment of the present invention, the non-magnetic layer 13 is formed below an entire surface of the free layer 11.

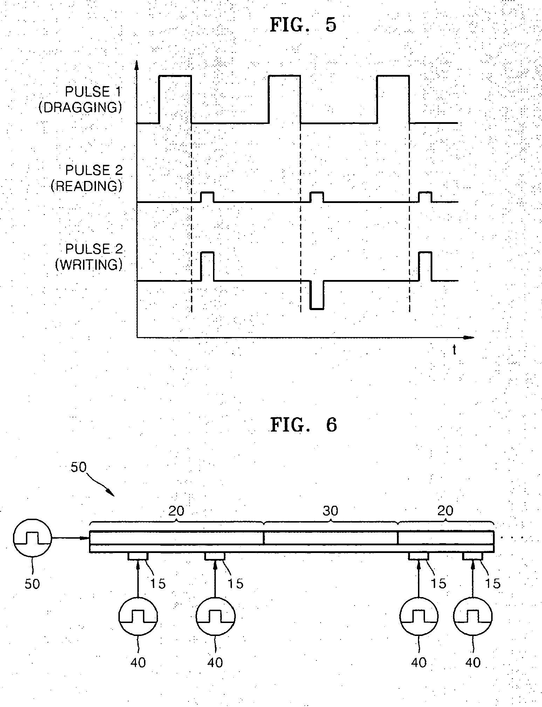

The magnetic device unit 10 drags the adjoining magnetic domains in the free layer 11 according to the dragging signal Pulse 1 applied through the second input portion 50 and magnetically reverses a portion of the magnetic region (i.e., a specific location corresponding to the reference layer 15) to store a data bit (i.e., 0 or 1) by a writing signal (e.g., Pulse 2 (writing) in FIG. 5) applied through the first input portion 40 by synchronizing with the dragging signal Pulse 1 using a current induced magnetic switching (CIMS) method (i.e., spin transfer torque).

Additionally, the magnetic device unit 10 drags the magnetic domains and applies a reading signal (a reading pulse signal) between the free layer 11 and the reference layer 15 according to the dragging signal Pulse 1 applied through the second input portion 50 and the reading signal (e.g., Pulse 2 (reading) in FIG. 5) applied through the first input portion 40 by synchronizing with the dragging signal pulse 1. Thus, the magnetic device unit 10 reads information data stored in the magnetic domain through a spin tunneling effect.

The Pulse 2 in FIGS. 1 and 2 is a reading signal or a writing signal.

The free layer 11 is formed to switch its magnetization direction and includes magnetic domain walls. The plurality of adjoining magnetic domains defined by the magnetic domain walls can be arranged on the free layer 11. The free layer 11 can be formed of a ferromagnetic material. The magnetic domain walls can be formed naturally. Also, according to various kinds and depositing conditions of the ferromagnetic material, the width of the magnetic domains, which are defined by the magnetic domain walls, can be adjusted. The magnetization directions of the magnetic domains can be switched independently.

In the magnetic device unit 10, storing data or reading data can be performed by area unit of the free layer 11, which corresponds to the effective size of the reference layer 15. The effective size of the reference layer 15 actually determines the size of a data bit area in the free layer 11.

Accordingly, the length of the free layer 11 may correspond to the product of the number of data bits to be stored and the effective size of the reference layer 15 (especially, the length in magnetic domain dragging direction). Accordingly, the data storage cell 20 includes a plurality of data bit regions in an array to store a plurality of bits of data therein by the effective size unit of the reference layer 15.

FIG. 1 is a view of first through sixth data bit regions, D1 to D6, each having a size corresponding to that of the reference layer 15 to store six bits of data. The number of data bit regions can be increased if necessary. In the magnetic device unit 10, each of the data bit regions D1 to D6 can be formed of a single magnetic domain having a magnetic domain barrier on both ends of each of the data bit regions D1 to D6, or more than two magnetic domains. That is, the data bit regions D1 to D6 include at least one magnetic domain.

The reference layer 15 has a pinned magnetization direction and is formed to correspond to a partial region (i. e., one data bit region) in adjoining magnetic domains of the free layer 11). The reference layer 15 can be formed of a ferromagnetic material. As FIG.1, the reference layer 15 may be formed below the third data bit region D3.

The non-magnetic layer 13 can be a conduction layer such as copper Cu, or an insulation layer such as an aluminum oxide layer serving as a tunneling barrier.

On the other hand, the first input portion 40 is electrically connected to at least one data bit region of the free layer 11 and the reference layer 15.

FIGS. 1 and 2 are views of when the first input portion 40 is electrically connected to the reference layer 15 and a single data bit region (hereinafter, referred to as a specific data bit region 21 if necessary) on the reference layer 15.

A writing signal is applied to the free layer 11 and the reference layer 15 through the first input portion 40. Thus, the writing signal determines the magnetization direction of the specific data bit region 21 on the reference layer 15. Referring to FIG. 1, the data storage cell 20 includes an array of the first through sixth data bit regions D1 to D6. The specific data bit region 21 connected electrically to the first input portion 40 becomes the third data bit region D3.

When the writing signal is applied through the first input portion 40, the writing signal determines the magnetization direction of the third bit region D3. For example, when the third data bit region D3 has a predetermined magnetization direction, the magnetization direction of the third data bit region D3 can be reversed or maintained according to the applied writing signal. This designed magnetization direction represents recorded bit of data.

The writing signal is a pulse-type switching current as show FIG. 5. The magnetization direction of the specific data bit region 21 (i.e., the third data bit region D3) in the free layer 11 on the reference layer 15 is selectively switched according to a polarity of the switching current so that a data bit (i.e., 0 or 1) to be stored is stored in the specific data bit region 21.

For example, when a predetermined switching current is applied, causing the magnetization direction of the specific data bit region 21 to be identical to that of the reference layer 15, a data bit is designated as zero "0". When a switching current of an opposite polarity is applied, causing the specific data bit region 21 to have a magnetization direction (an anti-parallel direction) opposite to that of the reference layer 15, the data bit is designated as one "1". Thus, the data is stored by changing the polarity of a switching current to make the magnetization direction of the specific data bit region identical to that of the reference layer 15, or opposite to that of the reference layer 15. Referring to FIG. 1, arrows in the first through sixth data bit regions D1 to D6 represent magnetization directions.

On the other hand, a reading signal (e.g., Pulse 2 (reading) in FIG. 5) is applied to the specific data bit region 21 of the free layer 11 and the reference layer 15 through the first input portion 40 during a data reading period. At this point, the reference layer 15, the specific data bit region 21 of the free layer 11 on the reference layer 15, and the non-magnetic layer 13 therebetween constitute a magnetic tunnel junction (MTJ) cell. Amount of current passing through the MTJ cell and a resistance of the MTJ cell are changed according to whether the magnetization direction of the specific data bit region 21 is parallel or anti-parallel to the reference layer 15. Using this property, a data reading operation is performed.

As illustrated in FIG. 5, the pulse current for reading is smaller than the switching current for writing. The pulse current for reading is synchronized with the dragging signal for domain dragging, and then is applied. The stored data information can be read according to the magnetization direction of the specific data bit region 21.

The second input portion 50 is electrically connected to the free layer 11 in order to drag data (i.e., a magnetization direction) stored in a data bit region of the free layer 11 to an adjacent data bit region. According to a dragging signal Pulse 1 inputted and applied through the second input portion 50, the magnetization direction of the magnetic domain is dragged to an adjacent magnetic domain. Accordingly, the data bit of a predetermined data bit region is moved to an adjacent data bit region. This is called magnetic domain dragging.

The dragging signal Pulse 1 can be a pulse current, which is applied during a predetermined interval. The dragging signal Pulse 1 can be applied to perform magnetic domain dragging in a data bit region unit having at least one magnetic domain. Here, since the magnetic domain dragging actually moves a magnetization direction of a predetermined magnetic domain toward an adjacent magnetic domain, the dragging signal Pulse 1 is maintained during the magnetic domain dragging in each data bit region unit, and periodically applied to perform the magnetic domain dragging by a data bit region unit.

The switching current signal for writing or, the reading pulse current signal, and a dragging signal are applied alternately. Accordingly, a data storing operation or a data reading operation, and magnetic domain dragging operation are performed alternately. Additionally, a plurality of bits of data can be sequentially stored in a plurality of data bit regions or sequentially read from the plurality of data bit regions.

On the other hand, the magnetic device unit 10 further includes a buffer cell 30 adjoining the storage cell 20 in at least one side of the storage cell 20 to store data, which is dragged beyond outside the data storage cell 20 region according to the magnetic domain dragging.

When the data storage cell 20 includes n data bit regions, the buffer cell 30 may include n or n-1 data bit regions. That is, the number of data bit regions in the buffer cell 30 is identical to, or one less than the number of data bit regions of the data storage cell 20. Physical characteristics of the free layer 11 in the data storage cell 20 and the buffer cell 30 are identical. In FIGS. 1 and 2, a middle portion of the free layer 11 is used as the data storage cell 20, and both side portions of the free layer 11 are used as the buffer cell 30. Since a writing signal or a reading signal is not directly applied to the buffer cell 30, the buffer cell 30 may include only the free layer 11 or a layer structure with the free layer 11, and the non-magnetic layer 13 below the free layer 11. According to the magnetic device unit 10 of the present invention, the buffer cell 30 may have a layer structure identical to that of the data storage cell 20. The layer structure includes the reference layer 15. A signal may not be applied to the reference layer 15 of the buffer cell 30.

Referring to FIGS. 1 and 2, data storing or data reading is performed in the third data bit region D3 of the data storage cell 20. The buffer cell 30 includes a first portion A and a second portion B on both sides of the data storage cell 20. When magnetic domain dragging is performed from left to right during data reading, the first portion A of the buffer cell 30 includes three data bit regions on the left side of the data storage cell 20, and the second portion B of the buffer cell 30 includes two data bit regions on the right side of the data storage cell 20. The reading of the data in the six data bit regions D1 to D6 of the data storage cell 20 can be initiated by dragging the data in the six data bit regions D1 to D6 to the left to place a position of a sixth data bit region D6 on a position of the third data bit region D3. And then, reading the data and dragging the data region to the right are performed alternately until all the data in the six data bit regions D1 to D6 are read.

Referring to FIGS. 1 and 2, the reference layer 15 is formed on the middle of the data storage cell 20, and the data storing or reading operation is performed on the middle of the data storage cell 20. However, the present invention is not limited thereto.

For example, storing data or reading data can be performed in the first data bit region D1 of the data storage cell 20. The buffer cell 30 has a number of data bit regions, identical to, or one less than the number of the data bit regions in the data storage cell 20. The buffer cell 30 can be placed adjacent to the data bit region where a data reading operation or a data storing operation of the data storage cell 20 begins (e.g., when a data reading operation or a data storing operation begins at the first data bit region D1, the buffer cell 30 is at the left side of the data storage cell 20, and when a data reading operation or a data storing operation begins at the sixth data bit region D6, the buffer cell 30 is at the right side of the data storage cell 20), or on both sides of the data bit region. This example can be inferred from the structure of FIGS. 1 and 2, and thus will be omitted for conciseness.

When the buffer cell 30 is located at the right or the left of the data storage cell 20, the data of the data storage cell 20 is dragged toward the buffer cell 30, and then the data reading operation can be performed during a data reading period. At this point, magnetic domain dragging performed during the data reading, and magnetic domain dragging performed during the data storing are performed in the same direction. Alternatively, when data of the data storage cell 20 is moved to the buffer cell 30, the data reading can be performed. At this point, the magnetic domain dragging performed during the data reading, and magnetic domain dragging performed during the data storing are in an opposite direction.

When n bits of data are stored in the data storage cell 20, the number of data bit regions in the buffer cell 30 may be one less than the number of data bit regions in the data storage cell 20. The reason is as follows. The buffer cell 30 may be formed to store n-1 bits of data. This is because that the one bit of data can be stored in the data bit region where data reading or data storing of the data storage cell 20 is performed and n-1 bits of data can be temporarily stored in the buffer cell 30.

When the buffer cell 30 is on both sides of the data storage cell 20, data of the data storage cell 20 can be read during performing magnetic domain dragging without moving the data to the buffer cell 30 before reading operation. The magnetic domain dragging performed during the data reading, and the magnetic domain dragging performed during the data storing are performed in opposite directions. In this case, when the n-bit data is stored in the data storage cell 20, the number of data bit regions in the buffer cell 30 on both sides of the data storage cell 20 may be one less than the number of the data bit regions in the data storage cell 20.

On the other hand, while the magnetic device unit 10 having the buffer cell 30 adjoining the data storage cell 20 has been illustrated and described, the magnetic device unit 10 can include only the data storage cell 20 without the buffer cell 30. For example, the data storage cell 20 can include an additional data bit region serving as a buffer by adding the number of bits to be stored in the data bit region to the data storage cell 20. For example, when n bit data is stored, a 2n or 2n-1 data bit region can be formed to the data storage cell 20.

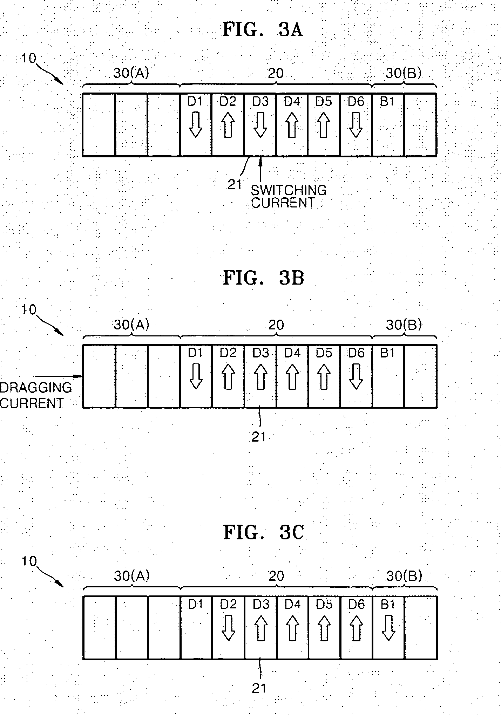

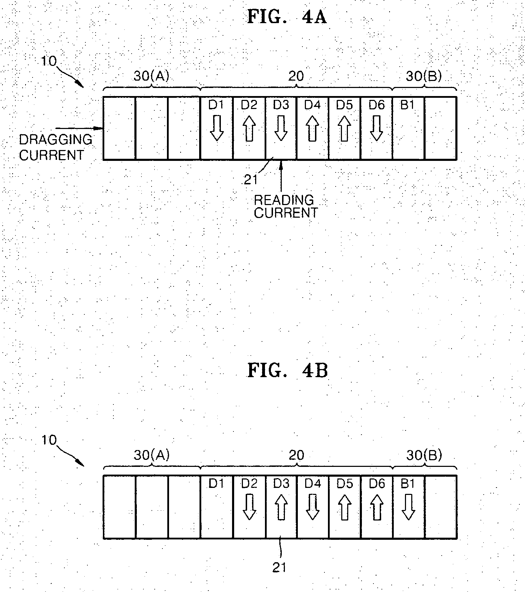

In the magnetic device unit 10 according to the current embodiment of the present invention, a switching current for writing or a pulse current for reading and a dragging current are applied alternately. Thus, a data storing operation or a data reading operation and magnetic domain dragging operation are performed alternately. The data storing and data reading operations of the magnetic device unit 10 will be described with reference to FIGS. 3A through 3C, 4A and 4B.

FIGS. 3A through 3C are views illustrating that a magnetization direction of the third data bit region D3 (the specific data bit region 21) of FIGS. 1 and 2 is reversed by applying a switching current and then a reversed magnetization direction of the third data bit region D3 is dragged to the adjacent fourth data bit region D4 by a dragging current. FIGS. 4A and 4B are views illustrating that a magnetization direction of the third data bit region D3 (the specific data bit region 21) is read by applying a reading pulse current to the third data bit region and is dragged to the adjacent fourth data bit region D4 by a dragging current. FIG. 5 is a graph of a dragging current signal Pulse 1 (Dragging), a reading pulse current signal Pulse 2 (reading), and a switching writing pulse current signal Pulse 2 (writing), which are applied to a magnetic device unit 10 according to an embodiment of the present invention. The horizontal axis of FIG. 5 is a time (t) axis.

The data storing operation is performed as follows. When a switching current is applied to the third data bit region D3 in FIG. 3A, the magnetization direction of the third data bit region D3 is reversed in FIG. 3B. Next, when a dragging current is applied to the free layer 11, the magnetization direction of each data bit region is dragged toward an adjacent data bit region as illustrated in FIG. 3C. That is, the magnetization direction of the first through sixth data bit regions D1 to D6 in the data storage cell 20 of FIG. 3B is dragged toward the second through sixth data bit regions D2 to D6 and a first data bit region B1 of the second portion B of the buffer cell 30 by one data bit region.

As described above, the magnetization direction of the specific data bit region 21 is designated, and then the data (the magnetization direction) of the specific data bit region 21 is dragged toward the data bit region (i.e., the fourth data bit region D4) after a predetermined time. Next, a writing signal is applied again to the specific data bit region 21 to designate the magnetization direction. By periodically applying the dragging current and the switching current for writing in synchronization with the dragging current, this magnetization direction designation and dragging are performed alternately. Thus, a plurality of bits of data are stored in an array of a plurality of data regions on the free layer 11. After completing the data storing, an original data storing position is maintained, or the data is stored in the first through sixth data bit regions D1 to D6 of the data storage cell 20 by applying a dragging signal that drags the magnetic domain in an opposite direction.

The reading of the stored data is performed as follows. Referring to FIG. 4A, when a reading pulse current is applied to the third data bit region D3, data of the third data bit region D3 can be read. A dragging current is applied to the free layer 11 as illustrated in FIG. 4B, and then the magnetization direction of each data bit region is dragged into an adjacent data bit region. The magnetization direction of the first through sixth data bit regions D1 to D6 in the data storage cell 20 of FIG. 4A is dragged toward the second through sixth data bit regions D2 to D6 and the first data bit region B1 of the second portion B of the buffer cell 30 by one data bit region.

As described above, the magnetization direction of the specific data bit region 21 is read, and then the data (the magnetization direction) of the specific data bit region 21 is dragged toward the data bit region (i.e., the fourth data bit region D4) after a predetermined time. Next, a reading signal is applied again to the specific data bit region 21 to read the magnetization direction of the specific data bit region 21. By periodically applying the dragging current and the pulse current for reading in synchronization with the dragging current, the data reading and dragging operations are performed alternately until the completion of the reading of a plurality of bits of data stored in the free layer 11. After the completion of the data reading, an original data storing position is maintained, or the data is stored in the first through sixth data bit regions D1 to D6 of the data storage cell 20 by applying a dragging signal that drags the magnetic domain in an opposite direction.

During the data reading operation, the pulse current for reading is synchronized with the domain dragging signal without reversing polarity as illustrated in FIG. 5, and then periodically applied. When the pulse current for reading is applied between the reference layer 15 and the specific data bit region of the free layer 11, for example, a current passing a tunnel barrier is changed according to whether the magnetization directions of the reference layer 15 and the specific data bit region of the free layer 11 are parallel or anti-parallel. Accordingly, a resistance value when the reference layer 15 and specific data bit region of the free layer 11 have an identical magnetization direction is smaller than a resistance value when the reference layer 15 and specific data bit region of the free layer 11 have an opposite magnetization direction to each other. According to the above resistance difference, a data value stored in the specific data bit region can be recognized.

In the magnetic device unit 10 according to the current embodiment of the present invention, a magnetic device (i.e., MTJ or GMR) for reading data, and a magnetic device for writing using a spin transfer torque method are embodied in a single device. However, the present invention is not limited thereto. That is, the magnetic device unit 10 according to the current embodiment of the present invention can be applied as a magnetic device (i.e., MTJ or GMR) for reading a plurality of bits of data through magnetic domain dragging, or as a magnetic device for writing using a spin transfer torque a plurality of bits of data through magnetic domain dragging.

FIG. 6 is a view of a magnetic device unit 50 according to another embodiment of the present invention. The magnetic device unit 50 can include a plurality of data storage cells 20. Additionally, the magnetic device unit 50 can further include a buffer cell 30 adjoining the storage cells 20 to store data, which is dragged beyond the outside of the data storage cells 20 according to magnetic domain dragging. At this point, at least one first input portion 40 is formed to correspond to each of the data storage cells 20. When there are a plurality of data storage cells 20 and at least one first input portion 40 corresponding to each of the data storage cells 20, the data storage capacity increases as much as the number of the data storage cells 20, and a data storing or data reading speed can be achieved, which is identical to, or much faster than that of the previous embodiment of the present invention.

In FIG. 6 the buffer cell 30 is disposed between two data storage cells 20. In a structure having a plurality of data storage cells 20, the buffer cell 30 can be placed at least one position of positions before a first data storing cell and after a last data storing cell, and between two adjacent data storage cells, respectively.

On the other hand, referring to FIG. 6, one data storage cell 20 includes two reference layers 15 and two first input portions 40. When the one data storage cell 20 includes a plurality of the first input portions 40, a data storing speed or a data reading speed can be improved.

In another example, when one data storage cell 20 includes a plurality of the reference layers 15 and the first input portions 40, a writing signal and a reading signal can be applied through respectively different first input portions 40 in the magnetic device unit 50. Additionally, a data storage cell 20 to which a writing signal is applied can be separated from a data storage cell 20 that reads the stored data.

As described above, the magnetic device unit of the present invention comprises a data storage cell including a free layer and a reference layer and storing a plurality of bits of data. The free layer may be switched a magnetization direction and has a plurality of adjoining magnetic domains. The reference layer is formed to correspond to a partial region of the free layer and have a pinned magnetization direction. The data storage cell is constituted to form a plurality of data bit regions in an array on the free layer. The data storage cell stores a plurality of bits of data in the array using the effective size unit of the reference layer. Additionally, a data storing operation or a data reading operation, and magnetic domain dragging operation are performed alternately. The magnetic domain dragging operation drags data in data bit region of the free layer toward an adjacent data bit region. Thus, a plurality of bits of data can be stored or read.

Therefore, since a plurality of bits of data can be stored in each cell applied the magnetic device unit of the present invention, data storage capacity of the magnetic device unit can drastically increase. Accordingly, a magnetic device (e.g., MRAM) having a significantly increased data storage capacity can be achieved.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A magnetic device unit comprising:
a data storage cell (20) comprising a free region (11) having a switchable magnetization direction and having a plurality of adjoining magnetic domains;
wherein a plurality of data bit regions (21) are formed in an array on the free region to allow the data storage cell to store a plurality of bits of data in the array;
a first input portion (40) electrically connected to at least one of the data bit regions of the free region to apply at least one of a writing signal and a reading signal (PULSE 2), and
a second input portion (50) electrically connected to the free region to drag data stored in the data bit regions of the free region toward an adjacent data bit region by applying a dragging signal (PULSE 1) for magnetic domain dragging;
**characterised in that** the free region is a free layer, and **in that** the data storage cell further comprises a reference layer (15) formed adjacent to said free layer (11) and corresponding to a portion of the free layer (11) and having a pinned magnetization direction to define the size of each of the data bit regions to be an effective size unit of the reference layer.

2. The magnetic device unit of claim 1, wherein the writing signal is a switching current in a pulse form.

3. The magnetic device unit of claim 2, wherein the reading signal is a pulse current smaller than the switching current.

4. The magnetic device unit of claim 3, arranged to supply one of the switching current and the pulse current for reading, alternately with the dragging signal, so that one of a data storing operation and a data reading operation, and magnetic domain dragging operation are performed alternately.

5. The magnetic device unit of claim 4, wherein each of the data bit regions (21) comprises at least one magnetic domain, and magnetic domain dragging is performed by a data bit region unit.

6. The magnetic device unit of any preceding claim, wherein each of the data bit regions (21) comprises at least one magnetic domain, magnetic domain dragging is performed by a data bit region unit, and one of the data storing operation and the data reading operation, and the magnetic domain dragging operation are performed alternately.

7. The magnetic device unit of any preceding claim, further comprising a non-magnetic layer (13) between the reference layer (15) and the free layer (11).

8. The magnetic device unit of claim 7, wherein the non-magnetic layer (13) is a conduction layer.

9. The magnetic device unit of claim 7, wherein the non-magnetic layer (13) is an insulation layer serving as a tunneling barrier.

10. The magnetic device unit of any preceding claim, further comprising a buffer cell (30) that adjoins the data storage cell and is formed on at least one side of the data storage cell (20) to store data dragged beyond an outside of the data storage cell according to magnetic domain dragging.

11. The magnetic device unit of claim 10, wherein a plurality of data storage cells (20) are formed, the buffer cell (30) is located between two adjacent data storage cells, and at least one first input portion (40) is formed per data storage cell.

12. The magnetic device unit of any preceding claim, wherein the plurality of data storage cells (20) are formed in an array, and at least one first input portion (40) is formed per data storage cell.

13. A method of operating a magnetic device unit according to any of the preceding claims comprising:
applying to the reference layer (15) at least one of said writing signal and said reading signal.

## Patentansprüche

1. Magnetische Bauteileinheit, umfassend:
eine Datenspeicherzelle (20) umfassend einen freien Bereich (11) mit einer umschaltbaren Magnetisierungsrichtung und mit einer Mehrzahl von angrenzenden magnetischen Domänen,
wobei eine Mehrzahl von Datenbitbereichen (21) in einer Matrix auf dem freien Bereich so ausgebildet sind, dass die Datenspeicherzelle eine Mehrzahl von Datenbits in der Matrix speichern kann,
einen ersten Eingabebereich (40), der mit mindestens einem der Datenbitbereiche des freien Bereichs elektrisch verbunden ist, um ein Schreibsignal und/oder ein Lesesignal (PULSE2) anzulegen, und
einen zweiten Eingabebereich (50), der mit dem freien Bereich elektrisch verbunden ist, um in den Datenbitbereichen der freien Schicht gespeicherte Daten zu einem benachbarten Datenbitbereich zu verschieben, indem ein Verschiebungssignal (PULSE1) für ein Verschieben magnetischer Domänen angelegt wird,
**dadurch gekennzeichnet, dass** der freie Bereich eine freie Schicht ist, und dadurch, dass die Datenspeicherzelle ferner eine Referenzschicht (15) umfasst, die benachbart zur freien Schicht (11) ausgebildet ist und einem Abschnitt der freien Schicht (11) entspricht und eine gepinnte Magnetisierungsrichtung aufweist, um die Größe jedes der Datenbitbereiche auf eine effektive Größeneinheit der Referenzschicht zu definieren.

2. Magnetische Bauteileinheit nach Anspruch 1, wobei das Schreibsignal ein Umschaltstrom in Pulsform ist.

3. Magnetische Bauteileinheit nach Anspruch 2, wobei das Lesesignal ein Pulsstrom ist, der kleiner ist als der Umschaltstrom.

4. Magnetische Bauteileinheit nach Anspruch 3, die dazu ausgebildet ist, dass sie den Umschaltstrom oder den Pulsstrom zum Lesen abwechselnd mit dem Verschiebungssignal zuführt, so dass eine Datenspeicheroperation oder eine Datenleseoperation und eine Verschiebungsoperation magnetischer Domänen abwechselnd ausgeführt werden.

5. Magnetische Bauteileinheit nach Anspruch 4, wobei jeder der Datenbitbereiche (21) mindestens eine magnetische Domäne umfasst und ein Verschieben magnetischer Domänen um eine Datenbitbereichseinheit ausgeführt wird.

6. Magnetische Bauteileinheit nach einem der vorhergehenden Ansprüche, wobei jeder der Datenbitbereiche (21) mindestens eine magnetische Domäne umfasst, Verschieben magnetischer Domänen um eine Datenbitbereichseinheit ausgeführt wird und die Datenspeicheroperation oder die Datenleseoperation und die Verschiebungsoperation magnetischer Domänen abwechselnd ausgeführt werden.

7. Magnetische Bauteileinheit nach einem der vorhergehenden Ansprüche, ferner umfassend eine nichtmagnetische Schicht (13) zwischen der Referenzschicht (15) und der freien Schicht (11).

8. Magnetische Bauteileinheit nach Anspruch 7, wobei die nichtmagnetische Schicht (13) eine Leiterschicht ist.

9. Magnetische Bauteileinheit nach Anspruch 7, wobei die nichtmagnetische Schicht (13) eine Isolierschicht ist, die als Tunnelungsbarriere dient.

10. Magnetische Bauteileinheit nach einem der vorhergehenden Ansprüche, ferner umfassend eine Pufferzelle (30), die an die Datenspeicherzelle angrenzt und auf mindestens einer Seite der Datenspeicherzelle (20) so ausgebildet ist, dass sie gemäß dem Verschieben magnetischer Domänen über eine Außenseite der Datenspeicherzelle hinaus gezogene Daten speichert.

11. Magnetische Bauteileinheit nach Anspruch 10, wobei eine Mehrzahl von Datenspeicherzellen (20) ausgebildet ist, die Pufferzelle (30) zwischen zwei benachbarten Datenspeicherzellen gelegen ist und mindestens ein erster Eingabebereich (40) pro Datenspeicherzelle ausgebildet ist.

12. Magnetische Bauteileinheit nach einem der vorhergehenden Ansprüche, wobei die Mehrzahl von Datenspeicherzellen (20) in einer Matrix ausgebildet ist und mindestens ein erster Eingabebereich (40) pro Datenspeicherzelle ausgebildet ist.

13. Verfahren zum Betreiben einer magnetischen Bauteileinheit nach einem der vorhergehenden Ansprüche, umfassend:
Anlegen des Schreibsignals und/oder des Lesesignals an die Referenzschicht (15).

## Revendications

1. Unité de dispositif magnétique, comprenant :
une cellule de stockage de données (20) comprenant une région libre (11) ayant une direction de magnétisation commutable et ayant une pluralité de domaines magnétiques contigus ;
dans laquelle une pluralité de régions de bits de données (21) est formée dans un tableau sur la région libre pour permettre à la cellule de stockage de données de stocker une pluralité de bits de données dans le tableau ;
une première partie d'entrée (40) connectée électriquement à au moins l'une des régions de bits de données de la région libre pour appliquer au moins un signal parmi un signal d'écriture et un signal de lecture (PULSE2) ; et
une deuxième partie d'entrée (50) connectée électriquement à la région libre pour déplacer des données stockées dans les régions de bits de données de la région libre vers une région de bits de données adjacente par l'application d'un signal de déplacement (PULSEL) pour un déplacement de domaine magnétique ;
**caractérisée en ce que** la région libre est une couche libre, et **en ce que** la cellule de stockage de données comprend en outre une couche de référence (15) formée de façon adjacente à ladite couche libre (11) et correspondant à une partie de la couche libre (11) et ayant une direction de magnétisation goupillée pour définir la dimension de chacune des régions de bits de données pour qu'elle présente une unité de dimension effective de la couche de référence.

2. Unité de dispositif magnétique selon la revendication 1, dans laquelle le signal d'écriture est un courant de commutation sous forme d'impulsion.

3. Unité de dispositif magnétique selon la revendication 2, dans laquelle le signal de lecture est un courant pulsé inférieur au courant de commutation.

4. Unité de dispositif magnétique selon la revendication 3, agencée pour fournir un courant parmi le courant de commutation et le courant pulsé pour la lecture, en alternance avec le signal de déplacement, de sorte qu'une opération parmi une opération de stockage de données et une opération de lecture de données, et une opération de déplacement de domaine magnétique sont effectuées en alternance.

5. Unité de dispositif magnétique selon la revendication 4, dans laquelle chacune des régions de bits de données (21) comprend au moins un domaine magnétique, et un déplacement de domaine magnétique est effectué par une unité de région de bits de données.

6. Unité de dispositif magnétique selon l'une quelconque des revendications précédentes, dans laquelle chacune des régions de bits de données (21) comprend au moins un domaine magnétique, un déplacement de domaine magnétique est effectué par une unité de région de bits de données, et une opération parmi l'opération de stockage de données et l'opération de lecture de données, et l'opération de déplacement de domaine sont effectuées en alternance.

7. Unité de dispositif magnétique selon l'une quelconque des revendications précédentes, comprenant en outre une couche non magnétique (13) entre la couche de référence (15) et la couche libre (11).

8. Unité de dispositif magnétique selon la revendication 7, dans laquelle la couche non magnétique (13) est une couche de conduction.

9. Unité de dispositif magnétique selon la revendication 7, dans laquelle la couche non magnétique (13) est une couche d'isolation servant de barrière de tunnellisation.

10. Unité de dispositif magnétique selon l'une quelconque des revendications précédentes, comprenant en outre une cellule tampon (30) qui est contiguë à la cellule de stockage de données et est formée sur au moins un côté de la cellule de stockage de données (20) pour stocker des données déplacées au-delà de l'extérieur de la cellule de stockage de données selon le déplacement de domaine magnétique.

11. Unité de dispositif magnétique selon la revendication 10, dans laquelle une pluralité de cellules de stockage de données (20) est formée, la cellule tampon (30) est située entre deux cellules de stockage de données adjacentes, et au moins une première partie d'entrée (40) est formée par cellule de stockage de données.

12. Unité de dispositif magnétique selon l'une quelconque des revendications précédentes, dans laquelle la pluralité de cellules de stockage de données (20) est formée en un tableau, et au moins une première partie d'entrée (40) est formée par cellule de stockage de données.

13. Procédé d'exploitation d'une unité de dispositif magnétique selon l'une quelconque des revendications précédentes, comprenant l'étape consistant à :
appliquer à la couche de référence (15) au moins un signal parmi ledit signal d'écriture et ledit signal de lecture.
